# EUROPEAN PATENT SPECIFICATION

(11) **EP 4 368 565 B1**
(45) Date of publication and mention of the grant of the patent: **19.03.2025**
(21) Application number: 22212145.1
(22) Date of filing: 08.12.2022
(51) Int. Cl.: B81C 99/00, B29C 59/02, B29C 59/00, B06B 3/00, B06B 1/02, B06B 1/06

(54) **SYSTEM FOR FORMATION OF MICROSTRUCTURES IN POLYMERIC MATERIALS WITH 2D PIEZOELECTRIC DRIVE**
SYSTEM ZUR BILDUNG VON MIKROSTRUKTUREN IN POLYMERMATERIALIEN MIT PIEZOELEKTRISCHEM 2D-ANTRIEB
SYSTÈME DE FORMATION DE MICROSTRUCTURES DANS DES MATÉRIAUX POLYMÈRES À COMMANDE PIÉZOÉLECTRIQUE 2D

(30) Priority: 10.11.2022 LT 2022541
(43) Date of publication of application: 15.05.2024
(73) Proprietor: Kaunas University of Technology, 44249 Kaunas (LT)
(72) Inventor: Janusas, Giedrius, Karmelavos II kaimas, Kauno raj. (LT); Palevicius, Arvydas, Kaunas (LT); Ostasevicius, Vytautas, Domeikavos kaimas, Kauno raj. (LT); Bubulis, Algimantas, Kaunas (LT); Jurenas, Vytautas, Kaunas (LT); Ciganas, Justas, Siauliu raj. (LT)
(74) Representative: Pakeniene, Ausra

(56) References cited:
- JP-A- H05 160 340
- US-A1- 2014 134 336
- US-A1- 2017 200 589
- LIN CHIEN-HUNG: "Ultrasonic nanoimprint lithography: a new approach to nanopatterning", JOURNAL OF MICRO/NANOLITHOGRAPHY, MEMS, AND MOEMS, vol. 5, no. 1, 1 January 2006 (2006-01-01), US, pages 011003, XP093074903, ISSN: 1932-5150, DOI: 10.1117/1.2172992
- SACKMANN J. ET AL: "Review on ultrasonic fabrication of polymer micro devices", ULTRASONICS., vol. 56, 1 February 2015 (2015-02-01), GB, pages 189 - 200, XP093074904, ISSN: 0041-624X, Retrieved from the Internet <URL:https://www.sciencedirect.com/science/article/pii/S0041624X14002297/pdfft?md5=f11821ea5aa8ef5ae9129af2ec55a00d&pid=1-s2.0-S0041624X14002297-main.pdf> [retrieved on 20230818], DOI: 10.1016/j.ultras.2014.08.007

## Description

### TECHNICAL FIELD

The invention belongs to the field of materials science, specifically, to the technology of manufacturing microstructures to create elements of microelectromechanical systems (MEMS).

### BACKGROUND OF THE INVENTION

There is a known method and a device for developing a MEMS sensor using thermal and mechanical pressure and a high-frequency vibration excitation (Amer Sodah 2020 Development and research of a microelectromechanical sensor for human health monitoring. Doctoral thesis, p. 106, page 62). In the indicated device, vibrations are excited using elastically connected piezoceramic rings with electrodes connected to a high-frequency generator. Piezoceramic rings are installed in the structure of the electromechanical transducer (sonotrode), which has a heat-emitting source at the end of the working part. According to a set program and a defined time sequence, microstructure formation is carried out by pressing the sonotrode into the forming material, at the same time, controlling the temperature regime and performing the effect of high-frequency vibrations. The disadvantage of the specified prototype is that the intended device for vibration excitation uses piezoceramic elements, which operating temperature cannot exceed 180° C, because at higher temperatures, piezoceramic elements depolarize and lose the piezo effect. Matching the temperature regime with mechanical pressure and high-frequency vibrations in time is a complex process depending on the functionality of the control elements.

There is a known production technology of MEMS elements, i.e. the formation of structural elements is the gradual use of lithography, galvanic and microcasting processes (Lin C H and Chen R 2006 Ultrasonic nanoimprint lithography: a new approach to nanopatterning J. Microlithgraphy, Microfabrication Microsyst.)*.* The presented innovative technological scheme of the MEMS elements' manufacturing process shows the main structural elements and the equipment used, in relation to the time of that process stage (Chi Hoon Lee, Phill Gu Jung, Sang Min Lee, Sang Hu Park, Bo Sung Shin, Joon-Ho Kim, Kyu-Youn Hwang, Kyoung Min Kim and Jong Soo Ko. 2010 Replication of polyethylene nano-microhierarchical structures using ultrasonic forming. Micromech. Microeng*.*). As shown in the diagram (a), the ultrasonic frequency generator excites mechanical vibrations in the electromechanical transducer of about 20kHz frequency, which are transmitted and amplified in the vibration concentrator. The ultrasonic vibrations of the concentrator due to the friction in the contact zone with the product generate relatively high energy, resulting in high temperature,which isused to join polymers or metals. This process takes place in a very short period of time (up to 3 seconds) and is ecologically clean and economical. The diagram (b) shows the sequence of the entire process: after contact with the forming element, the force pressing the polymer plate is increased to 690 N and stays stable for a while, and after,the surfaces are connected with the help of high-frequency vibrations. At that time, due to the friction of the surfaces, the molten polymer fills the cavities of the nanostructured form and after some time the polymer hardens. In the specified device, the temperature necessary for joining the surfaces is achieved due to the friction caused by high-frequency vibrations between the joining surfaces, which is difficult to achieve without a monitoring-control system.

The above listed microstructure forming system devices have one common disadvantage in MEMS formation, i.e., the formed structure is dependent on the initial shape of the given matrix, and if this matrix needs to be changed, the process requires to change the matrix and repeat the forming process. It is a rather complicated technology for producing a matrix of a different shape, and the replacement process itself takes a considerable amount of time. Another overview of the relevant technical field, showing an apparatus according to the preamble of claim 1 can be seen in the Journal Article, by Sackmann, J., et al. (2024); "Review on ultrasonic fabrication of polymer micro devices"; Elsevier B.V. Retrieved from ScienceDirect. Online ISSN 1874-9968, Accession Number: XP093074904.

### SUMMARY OF THE INVENTION

The invention comprises a system for forming microstructures in polymeric materials, which includes an electromechanical transducer, a sonotrode, a generator, a clamping mechanism, a tray with a material to be formed and two-coordinate (2D) precision positioning piezoelectric drive.

The presented system generates high-frequency vibrations in an electromechanical transducer, at the end of which a microstructure is fixed and during the pressing into the polymeric material at a specified time regime, microstructure is formed, corresponding to the structure of the free surface of the matrix.

After the formation of one structure in polymeric materials is completed, a high-frequency vibration signal from the generator is fed to one of the two precision positioning piezoelectric drives, which positions the polymer material workpiece in a given direction in the plane and thereby prepares the technological process for the formation of another structure in polymeric material.

Depending on the technical parameters (travel, resolution) of the precise positioning piezoelectric drive, it is possible to increase the efficiency of the forming process of microstructures in polymeric materials, i.e., to make dozens of microstructure (MEMS) elements with one matrix. In an electromechanical transducer, the piezo element used for vibration excitation constitutes the same class as precision positioning piezoelectric drives.

### SHORT DESCRIPTION OF DRAWINGS

The invention is explained in the drawings. The accompanying diagrams and drawings form an integral part of the invention description and are given as a reference to a possible embodiment of the invention, but are not intended to limit the scope of the invention.

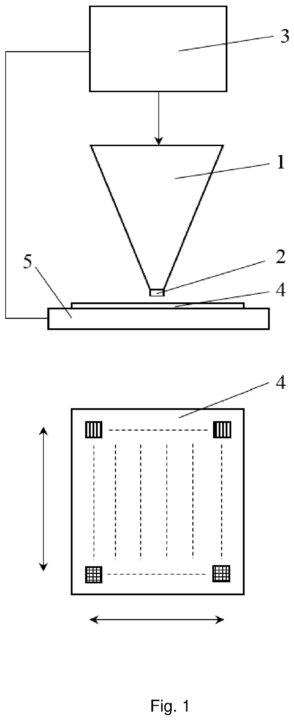

Fig. 1 shows the principal diagram of the system according to the invention.

### DETAILED DESCRIPTION OF THE INVENTION

As shown in Fig. 1, an example of the implementation of the system for forming microstructures in polymeric materials according to the invention comprises a vibrator (1) that excites high-frequency vibrations in a matrix (2) fixed at its free end, a vibration excitation-control generator (3), a polymer material workpiece (4) fixed in a tray (5), a precision positioning piezoelectric drive (6) for controlling the position of the tray (5) with respect to two coordinates, for example in the horizontal plane. The piezoelectric drive is controlled from the excitation-control generator (3), making it possible to change the position of the polymer material workpiece (4) in the horizontal plane according to the program created from the vibration excitation-control generator (3).

During the forming process of microstructures in polymeric materials, an electrical signal from the vibration excitation-control generator (3) is fed to the vibrator (1), which excites high-frequency mechanical vibrations in the free end of the fixed matrix (2), and the pressure on the polymer material workpiece (4) according to the set technological mode is performed by the formation of the microstructure, corresponding to the shape of the matrix (2).

In order to change the microstructure in the polymer material workpiece (4), positioning of the workpiece (4) is performed according to the set a program from the excitation-control generator (3) using a precision positioning piezoelectric drive (6). Thus, with the same matrix (2), when positioning in the plane according to the set program, it is possible to prepare a dozen variants of microstructures, i.e., MEMS elements.

In the electromechanical transducer, the piezo element used for vibration excitation constitutes the same class as precision positioning piezoelectric drives.

## Claims

1. A system for forming microstructures in polymeric materials includes a vibrator with a matrix attached to its free end, a vibration excitation-control generator, a polymer material workpiece and a workpiece tray, **characterized in that** the tray (5) of the polymer material workpiece (4) is connected to a precision positioning piezoelectric drive (6), for pallet position control in a two-dimensional space.

2. The system for forming microstructures in polymeric materials according to claim 1, **characterized in that** the precision positioning piezoelectric drive (6) and the vibrator (1) are controlled from the excitation-control generator (3) according to a compiled program.

## Patentansprüche

1. System zur Bildung von Mikrostrukturen in Polymermaterialien mit einem Vibrationsgerät, wobei eine Matrix an dessen freiem Ende angebracht ist, einem Vibrationsanregungssteuerungsgenerator, einem Werkstück aus Polymermaterial und einer Werkstückablage, **dadurch gekennzeichnet, dass** die Ablage (5) des Werkstücks (4) aus Polymermaterial mit einem piezoelektrischen Antrieb (6) mit Präzisionspositionierung verbunden ist, um eine Position von Paletten in einem zweidimensionalen Raum zu steuern.

2. System zur Bildung von Mikrostrukturen in Polymermaterialien nach Anspruch 1, **dadurch gekennzeichnet, dass** der piezoelektrische Antrieb (6) mit Präzisionspositionierung und das Vibrationsgerät (1) anhand des Anregungssteuerungsgenerators (3) gemäß einem kompilierten Programm gesteuert werden.

## Revendications

1. Système de formation de microstructures dans des matériaux polymères comprenant un vibrateur avec une matrice fixée à son extrémité libre, un générateur de commande d'excitation de vibration, une pièce en matériau polymère et un plateau de pièce, **caractérisé en ce que** le plateau (5) de la pièce en matériau polymère (4) est relié à un entraînement piézoélectrique de positionnement de précision (6), pour la commande de la position de palette dans un espace bidimensionnel.

2. Système de formation de microstructures dans des matériaux polymères selon la revendication 1, **caractérisé en ce que** l'entraînement piézoélectrique de positionnement de précision (6) et le vibrateur (1) sont commandés à partir du générateur de commande d'excitation (3) selon un programme compilé.
